# FASCICULE DE BREVET EUROPEEN

(11) **EP 1 307 929 B1**
(45) Date de publication et mention de la délivrance du brevet: **11.10.2006**
(21) Numéro de dépôt: 01967131.2
(22) Date de dépôt: 06.07.2001
(51) Int. Cl.: H01L 37/02

(54) **FABRICATION DE CAPTEURS PYROELECTRIQUES COMPRENANT UNE COUCHE PYROELECTRIQUE MINCE NECESSITANT UNE POLARISATION ELECTRIQUE**
HERSTELLUNGSVERFAHREN FÜR PYROELEKTRISCHE SENSOREN MIT EINER ELEKTRISCHE POLUNG BENÖTIGENDEN PYROELEKTRISCHEN DÜNNSCHICHT
METHOD FOR MAKING PYROELECTRIC SENSORS COMPRISING A THIN PYROELECTRIC FILM REQUIRING ELECTRIC POLARISATION

(30) Priorité: 04.08.2000 EP 00116868
(43) Date de publication de la demande: 07.05.2003
(73) Titulaire: Ecole Polytechnique Fédérale de Lausanne (EPFL), 1015 Lausanne (CH)
(72) Inventeur: WILLING, Bert, CH-1162 St-Prex (CH); MURALT, Paul, CH-1315 La Sarraz (CH)
(74) Mandataire: Surmely, Gérard
(86) Numéro de dépôt international: PCT/EP2001/007836
(87) Numéro de publication internationale: WO 2002/013283

(56) Documents cités:
- EP-A- 0 491 596
- PATENT ABSTRACTS OF JAPAN vol. 018, no. 064 (P-1685), 2 février 1994 (1994-02-02) & JP 05 281034 A (HORIBA LTD), 29 octobre 1993 (1993-10-29) -& JP 05 281034 A (HORIBA LTD) 29 octobre 1993 (1993-10-29)

## Description

La présente invention concerne la fabrication de capteurs pyroélectriques par formation d'une couche pyroélectrique mince à une face d'une même plaquette, notamment en silicium. Chaque capteur est formé de plusieurs pixels définis chacun par une première électrode propre située à une face de la couche pyroélectrique et une seconde électrode située à l'autre face de cette couche.

Un procédé de fabrication de tels capteurs pyroélectriques est connu du document JP 05 281034 A (HORIBA LTD), 29 octobre 1993.

De tels capteurs pyroélectriques présentent plusieurs utilisations, notamment pour la spectrométrie des gaz et l'imagerie thermique. Ils sont relativement peu onéreux. Cependant pour le bon fonctionnement de la couche pyroélectrique, il est généralement nécessaire qu'elle subisse une polarisation électrique; c'est-à-dire l'application d'un champ électrique entre deux électrodes qui a pour effet d'orienter les dipôles de la couche pyroélectrique au moins entre les premières et secondes électrodes des pixels. A titre d'exemple, on applique un champ électrique d'environ 30 V entre les premières et deuxièmes électrodes des pixels avec une température de la couche pyroélectrique située entre 110 à 170° C, pendant environ 10 minutes. Une pluralité de capteurs sont fabriqués en lot avec une technologie similaire à celle de la fabrication des circuits intégrés. Une plaque de silicium d'un diamètre de 10 cm peut contenir plusieurs centaines de capteurs formés soit des réseaux linéaires de pixels ou de réseaux bidimensionnels sous forme de matrice de pixels.

Un procédé de fabrication de tels capteurs doit permettre de polariser au moins des sous-ensembles de pixels de manière simultanée; une polarisation pixel par pixel devant être écartée pour des raisons évidentes. De préférence, il est prévu de polariser tous les pixels d'une même plaquette simultanément de manière à réduire les coûts et le temps de fabrication des capteurs. Pour polariser au moins un sous-ensemble de pixels, on prévoit de relier électriquement entre elles d'une part leurs électrodes supérieures et d'autre part leurs électrodes inférieures. Généralement, soit les électrodes supérieures, soit les électrodes inférieures sont reliées électriquement entre elles de façon permanente de manière à être mises lors du fonctionnement du capteur à un potentiel commun. Par contre, les autres électrodes doivent être isolées électriquement entre elles de manière à fournir des signaux électriques élémentaires.

En général, l'homme du métier prévoit de former les électrodes inférieures par une couche métallique définissant une électrode commune pour l'ensemble des pixels. Ceci permet d'économiser des étapes de fabrication. Ainsi, la plaquette de silicium présente une couche métallique traversante sur laquelle est déposé la couche pyroélectrique mince. Sur cette couche sont déposées les électrodes supérieures qui définissent géométriquement les pixels.

Dans l'exemple susmentionné, les électrodes supérieures du capteur doivent être isolées entre elles avant son utilisation, comme mentionné ci-avant. Cependant, pour polariser simultanément au moins un sous-ensemble de pixels, il est prévu de former des liaisons électriques temporaires entre les électrodes supérieures. En d'autres termes, il est prévu de relier électriquement pour effectuer la polarisation électrique également les électrodes prévues pour fournir les signaux électriques élémentaires des pixels. Ainsi, de préférence, on reliera l'ensemble de ces électrodes au moins par sous-ensembles reliés à un moins une plage de contact électrique prévue pour effectuer la polarisation.

Toutefois, un tel procédé présente un inconvénient majeur étant donné que tout court-circuit accidentel entre les électrodes d'un pixel entraînera une chute de tension pour tous les pixels du sous-ensemble concerné. La polarisation électrique devient ainsi impossible et une plaquette entière peut être perdue. Etant donné le nombre de capteurs fabriqués sur une même plaquette, un tel événement entraîne des pertes considérables, ce qui augmente de manière significative le prix de revient de tels capteurs dans une production industrielle.

Le but de la présente invention est de pallier l'inconvénient susmentionné tout en permettant une polarisation électrique simultanée pour au moins des sous-ensembles de pixels d'une plaque de capteurs en fabrication.

Ce but est atteint par l'objet de l'invention tel que défini à la revendication 1 qui concerne un procédé de fabrication d'une pluralité de capteurs pyroélectriques dans lequel il est prévu une étape où des liaisons électriques sont formées entre au moins un sous-ensemble de premières électrodes formant chacune une propre électrode d'un pixel et où il est également prévu de former des résistances électriques agencées de manière que chaque électrode dudit sous-ensemble soit reliée en série avec une de ces résistances.

Grâce à l'agencement des résistances électriques susmentionnées, un court-circuit au niveau d'un pixel n'entraîne plus un abaissement critique de la tension de polarisation appliquée lors d'une étape de polarisation ultérieure à l'étape susmentionnée. Ainsi, il est possible de polariser correctement les capteurs d'une plaquette même en présence d'un ou plusieurs court-circuits au niveau de certains pixels. Les pixels court-circuités sont bien évidemment inopérant dans le fonctionnement des capteurs fabriqués, mais ce problème reste localisé au seul pixel qui en subit un court-circuit accidentel.

De manière à diminuer encore les risques de court-circuits et de détériorations de capteurs, il est prévu dans le cadre de la présente invention selon un mode de réalisation préféré, de structurer également les électrodes destinées à être reliées entre elles à un potentiel de référence. Ainsi, les pixels sont définis par des électrodes inférieurs et supérieurs propres aux pixels. Ceci permet de réduire les capacités parasites formées par les électrodes. Ces secondes électrodes sont reliées au moins partiellement entre elles par des deuxièmes liaisons électriques, c'est-à-dire qu'elles sont reliées électriquement au moins par sous-ensembles correspondant de préférence aux sous-ensembles mentionnés précédemment.

Selon une variante de fabrication des capteurs, les premières et deuxièmes liaisons électriques reliant respectivement des électrodes supérieures et des électrodes inférieures présentent des croisements en projection dans le plan général de la plaquette. Pour éviter qu'un court-circuit entre ces première et deuxième liaisons électriques au niveau des croisements engendre une détérioration d'une partie des capteurs ou de l'ensemble par une chute de la tension de polarisation, les premières et deuxièmes liaisons sont agencées de manière que ces croisements soient situés entre les résistances et les électrodes auxquelles elles sont reliées.

Selon un mode de réalisation particulièrement avantageux, et bien adapté pour les réseaux linéaires de pixels ou pour les matrices à deux lignes de pixels, il est prévu que les liaisons entre les électrodes associées aux résistances de protection soient rompues automatiquement lors du sciage des capteurs.

D'autres modes et variantes de mise en oeuvre du procédé selon l'invention, ainsi que des avantages particuliers de l'invention seront décrits ci-après à l'aide de la description suivante, faite à l'aide du dessin ci-joint donné à titre d'exemples non limitatifs et dans lequel:
- la figure 1 montre partiellement et de manière schématique une vue de dessus d'une plaquette de capteurs pyroélectriques en fabrication selon un premier mode de mise en oeuvre du procédé selon l'invention;
- la figure 2 est une coupe selon le trait Il - Il de la figure 1;
- la figure 3 est une vue de dessus partielle et schématique d'une plaquette de capteurs pyroélectriques en fabrication selon un deuxième mode de mise en oeuvre du procédé selon l'invention.
- les figures 4 et 5 sont des coupes respectivement selon les traits IV - IV et V - V de la figure 3.

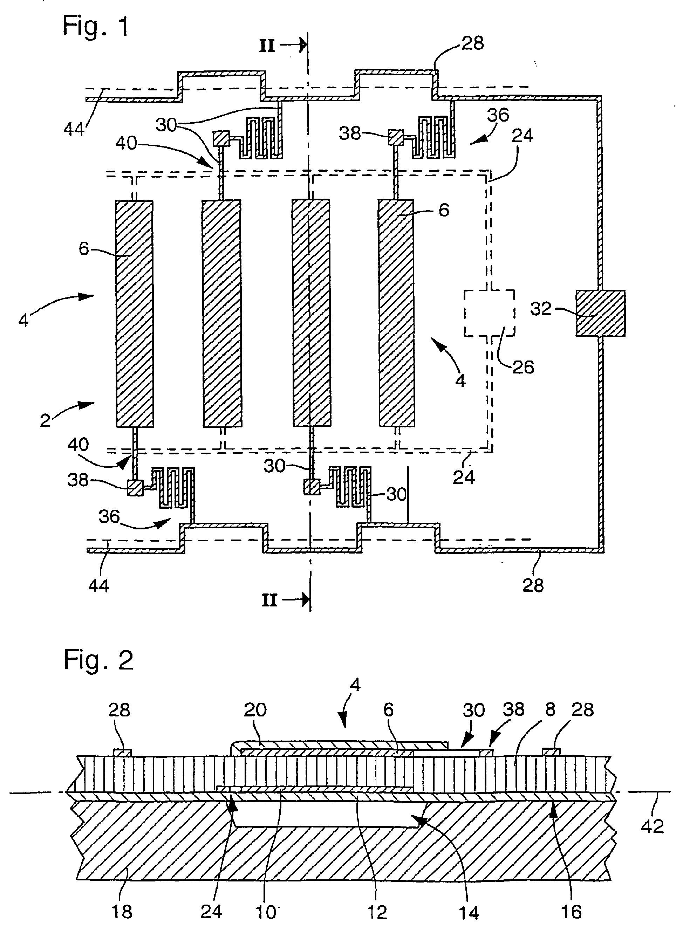

On décrira ci-après un premier mode de mise en oeuvre du procédé de fabrication selon l'invention à l'aide des figures 1 et 2. Sur la figure 1 est représenté partiellement un capteur 2 formé d'un réseau linéaire de pixels 4. Chaque pixel est défini par la géométrie d'une électrode supérieure 6 qui lui est propre. Chacun de ces pixels est formé d'une couche mince pyroélectrique 8 à la face supérieure de laquelle est formé l'électrode 6 et à la face inférieure de laquelle est prévue une électrode inférieure 10 formée sur une membrane 12. Sous la membrane 12, formée notamment en SiO₂ et /ou Si₃N₄ est prévu une cavité 14 pour isoler thermiquement chaque pixel.

Les capteurs sont formés à une face supérieure 16 d'une plaque en silicium 18. Sur cette plaquette peut être fabriqué des milliers de capteurs pyroélectriques. Lors de la fabrication de tels capteurs, il est possible de prévoir une électrode inférieure commune à l'ensemble des pixels d'un capteur, voire commune à l'ensemble des capteurs et formant une couche métallique traversant la plaquette. De même, la couche pyroélectrique 8 peut être commune aux pixels d'un capteur, voire à l'ensemble des capteurs d'une même plaquette. Par contre, dans le but d'isoler thermiquement les pixels entre elles, la couche 8 est généralement structurée au moins partiellement. Dans le cas de la figure 1, la couche 8 sera éliminée notamment dans les régions situées entre les électrodes 6. Finalement, une couche d'absorption 20, par exemple du platine noir, (non représentée à la figure 1) est déposée sur les électrodes supérieures.
Pour polariser électriquement la couche 8 entre les électrodes 6 et 10 de chaque pixel, les électrodes inférieures 10 sont reliées entre elles par des liaisons électriques 24 aboutissant à au moins une plage de contact électrique 26. De même, les électrodes supérieures sont reliées entre elles par des liaisons électriques temporaires formées de pistes principales 28 et de pistes secondaires 30 reliant chaque électrode 6 à une piste principale. Ces liaisons électriques sont donc formées selon le procédé de l'invention pour permettre de polariser simultanément au moins un sous-ensemble de pixels. Pour ce faire, les pistes principales 28 sont reliées à au moins une plage de contact électrique 32. On notera que pour une plaquette, il est prévu généralement plusieurs plages de contact 26 et/ou 32 reliant chacun un sous-ensemble d'électrodes inférieures et/ou d'électrodes supérieures des capteurs en fabrication.

Selon l'invention, il est prévu de former une résistance 36 pour chaque pixel 4, relié en série avec l'électrode supérieure ou inférieure de ce pixel. Dans l'exemple décrit ici, les résistances 36 sont reliées en série avec les électrodes 6 et situées le long des pistes secondaires 30. Les liaisons électriques des électrodes 6 à la plage 32 est prévue premièrement pour permettre d'effectuer une étape de polarisation électrique de la couche pyroélectrique 8 par application d'une tension entre les électrodes inférieures et supérieures, par l'intermédiaire des plages de contact 26 et 32. Deuxièmement, elles sont prévues pour le dépôt de la couche d'absorption 20 par un procédé électrochimique. A titre d'exemple, la résistance 36 a une valeur de l'ordre de 10 kΩ.

Comme cela a déjà été mentionné dans la partie introductive de la présente description, la résistance 36 sert premièrement à protéger la plaquette de capteurs en fabrication lors de l'étape de polarisation électrique. En effet, dans le cas où un court-circuit intervient dans un pixel entre les électrodes 4 et 6, la résistance 36 limite fortement le courant de fuite et empêche que la tension de polarisation chute; ce qui entraînerait autrement la perte d'au moins une partie de la plaquette et donc de milliers de capteurs. L'homme du métier saura sélectionner la plage de valeurs adéquates pour la résistance 36. Deuxièmement, ces résistances 36 servent à définir une impédance sensiblement égale pour chaque électrode supérieure 6, ce qui est avantageux pour permettre le dépôt de la couche d'absorption 20 de manière uniforme sur l'ensemble des électrodes supérieures.

Il est prévu une plage de contact individuelle 38 pour chaque pixel agencée entre l'électrode supérieure et la résistance.

Afin de réduire les risques de court-circuit entre les métallisations inférieures et supérieures relativement à la couche 8, il a été prévu dans le cas de la présente invention de structurer également l'électrode inférieure 10 et de relier ces électrodes par les pistes de liaison 24. Dans le but de protéger la pluralité de capteurs en cas de court-circuit entre les liaisons électriques inférieures et supérieures, il est prévu de préférence que les croisements de ces liaisons en projection dans le plan général 42 de la plaquette interviennent entre les électrodes 6 et les résistances 38 respectives. Ainsi, si un court-circuit accidentel intervient entre les liaisons 24 et 30, les résistances 36 protègent le reste des pixels et en particulier les capteurs non concernés par cette détérioration localisée.

Les pistes principales 28 sont réalisées en créneau et il est prévu, lors de la séparation d'un capteur de la plaquette, de scier cette plaquette selon les traits interrompus 44. Ainsi, lors du sciage, les liaisons électriques entre les électrodes supérieures sont automatiquement coupées de sorte que ces électrodes sont alors isolées électriquement les unes des autres. Les plages 38 servent à recevoir des signaux élémentaires des pixels et on remarquera que la résistance 36 est située de l'autre côté de l'électrode 6 relativement à la plage 38 de sorte qu'elle est inactive lors du fonctionnement du capteur.

On notera que les résistances 36 sont réalisées ici en couche(s) mince(s) essentiellement horizontale(s) et sont situées du côté de la face supérieure 16 de la plaquette 18. Ces résistances peuvent être agencées dans une ou plusieurs couches selon des techniques connues.

Dans le cas de capteurs matriciels formés de deux lignes de pixels, il est possible d'agencer les divers éléments de manière similaire à la figure 1, chacune des lignes de pixels ayant ses résistances agencées du côté opposé à l'autre ligne, alors qu'à la figure 1 les résistances sont agencées alternativement d'un côte et de l'autre des pixels. Dans le cas de matrice de pixel présentant plus de deux lignes, il est possible de prévoir des liaisons électriques temporaires agencées partiellement entre les pixels, notamment pour atteindre les électrodes non périphériques. Pour gagner de la place et conserver une haute densité de pixels par unité de surface, il est possible pour de grandes matrices de pixels d'agencer ces liaisons électriques dans une structure multicouche où différents niveaux de métallisation sont isolés les uns des autres selon des techniques de métallisation connues du domaine des semiconducteurs. Une telle réalisation permet d'assurer un micro-usinage seulement du côte de la face supérieure 16 de la plaquette 18. Par contre, les étapes de fabrication sont augmentées et l'isolation thermique des pixels peut être diminuée dans ce cas s'il n'est pas prévu d'enlever entre les pixels les liaisons électriques et leurs couches d'isolation. Une solution avantageuse pour les liaisons électriques nécessaires à la polarisation de capteurs bidimensionnels relativement étendus est donnée ci-après.

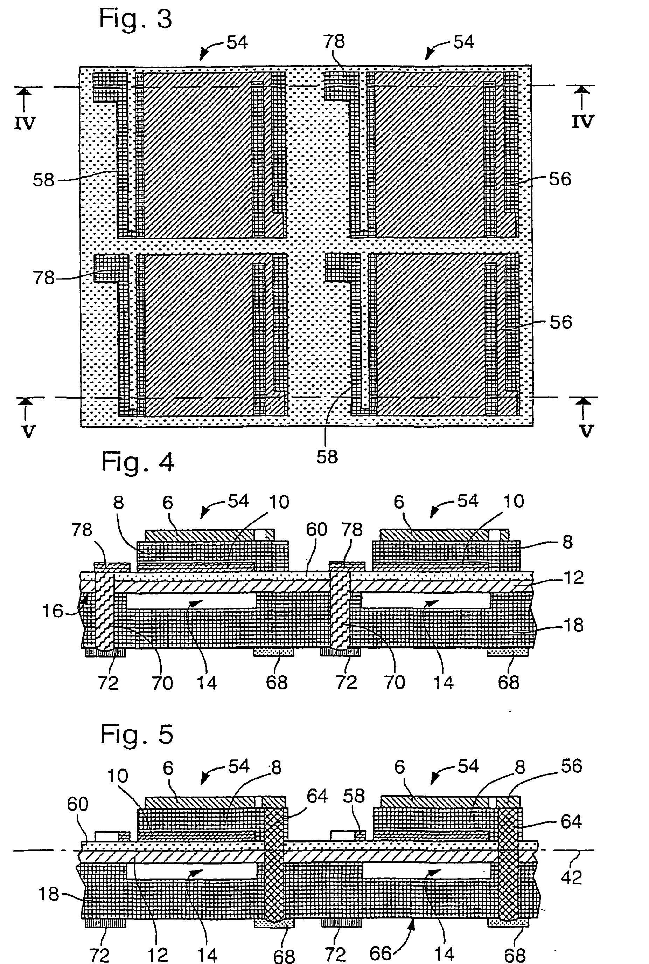

A l'aide des figures 3 et 4, on décrira ci-après un deuxième mode de mise en oeuvre du procédé selon invention. A la figure 3 est représenté partiellement un agencement de pixels sous forme matricielle. Seuls 4 pixels 54 sont représentés; mais un capteur peut être formé d'une matrice présentant plusieurs lignes et colonnes de pixels. Le procédé décrit ici peut s'appliquer sans autre à des capteurs formés d'un grand nombre de pixels. Les références déjà décrites précédemment ne le sont pas à nouveau ici.

Les pixels 54 sont formées d'électrodes inférieures 6 et supérieures 10 situées de chaque côte d'une couche pyroélectrique 8 structurée. Afin de protéger la couche 12 lors du micro-usinage de l'électrode 10 et de son bras de connection 58 par une attaque sèche, il est prévu une couche tampon ou couche d'arrêt 60 au-dessus de la couche 12. La couche 60 est relativement épaisse et forme aussi une barrière empêchant des interdiffusions entre la couche pyroélectrique et la membrane 12. De plus, elle agit comme couche d'adhésion pour l'électrode inférieure. Elle peut être constituée notamment de ZrO₂ TiO₂ ou autres oxydes similaires, résistant à l'oxydation et aux réactions avec la couche pyroélectrique.

Les liaisons électriques entre les électrodes supérieures sont effectuées au moyen de vias conducteurs 64 reliant les bras de connection 56 agencés sur la couche 8 à des pistes 68 agencées à la face inférieures 66 de la plaquette 18. Les liaisons entre les électrodes supérieures sont donc effectuées par le dessous de la plaquette ou du capteur considéré. De même, les électrodes inférieures 10 sont reliées électriquement entre elles au moyen de vias 70 reliant verticalement les bras 58 à des pistes conductrices 72 situées sur la face arrière 66 de la plaquette 18. Les pistes 68 et72 sont rectilignes et traversent la plaquette 18 pour connecter des rangées d'électrodes supérieures et inférieures. Elles présentent à au moins une extrémité une plage de contact électrique. L'agencement décrit ci-dessus permet d'effectuer une polarisation simultanée de l'ensemble des pixels agencés sur la plaque 18.

Selon l'invention, il est prévu que les vias 64 ou 70 forment des résistances de protection de la plaquette en fabrication lors de la polarisation électrique des pixels. A l'exemple donnée ici, ce sont les vias 70 qui forment les résistances électriques de protection. Après l'étape de polarisation, il est prévu de préférence d'éliminer les liaisons électriques entre les électrodes inférieures en enlevant les pistes 72 par une attaque chimique ou sèche, par un polissage mécanique chimique (CMP) ou encore par des sectionnements au laser. Par contre, il peut être avantageux de conserver les pistes 68 de manière à pouvoir mettre les électrodes supérieures d'un capteur à un même potentiel électrique. Afin de récolter les signaux électriques élémentaires des pixels, il est prévu des plages de contact 78 situées entre l'électrode 10 et la résistance 70. Cependant, il est aussi possible de prévoir ces plages 78 sur la face arrière 66 de la plaquette, par exemple aux extrémités des vias 70 débouchant sur cette face arrière. L'utilisation de vias permet donc de résoudre le problème d'encombrement lié aux liaisons électriques nécessaires et permet d'agencer avantageusement les résistances de protection au niveau des vias.

D'autres variantes peuvent être également conçues par l'homme du métier sans sortir du cadre de la présente invention, qui est définie par la revendication 1. En particulier il est possible de prévoir des liaisons électriques par la face arrière de la plaquette pour les électrodes inférieures mais de prévoir les liaisons électriques pour les électrodes supérieures du côté de la face avant 16, c'est-à-dire au-dessus de la couche 60 et en particulier au-dessus de la couche pyroélectrique, comme exposé dans le premier mode de mise en oeuvre de l'invention. Dans une telle réalisation mixte, les résistances peuvent être agencées soit au niveau des vias ou au niveau de la métallisation des électrodes supérieures.

On notera aussi qu'il peut être prévu d'agencer des résistances électriques sur la face arrière 66 de la plaquette.

## Revendications

1. Procédé de fabrication d'une pluralité de capteurs pyroélectriques (2) par formation d'une couche pyroélectrique mince (8) à une face d'une même plaquette (18), notamment en silicium, définissant un plan général (42), chaque capteur (2) étant formé de plusieurs pixels (4; 54) définis chacun par une première électrode propre (6) située à une face de ladite couche pyroélectrique (8) et une seconde électrode (10) située à l'autre face de cette couche (8), ce procédé comportant au moins les étapes successives suivantes :
A) Formation de premières liaisons électriques (28, 30; 56, 64, 68) entre au moins un sous-ensemble de premières électrodes (6) de ladite pluralité de capteurs (2) reliant ces premières électrodes (6) à au moins une plage de contact électrique (32);
B) Polarisation électrique de ladite couche pyroélectrique (8) entre les premières (6) et secondes (10) électrodes par application d'une tension électrique entre ladite au moins une plage de contact électrique (32) et lesdites secondes électrodes (10) des pixels (4; 54) correspondant audit au moins un sous-ensemble de premières électrodes (6);
C) Isolation électrique desdites premières (6) et/ou secondes (10) électrodes d'au moins un capteur (2) les unes des autres,
ce procédé étant **caractérisé en ce que** lors de ladite étape A des résistances électriques (36; 64) sont formées et agencées de manière que chaque première électrode (6) dudit au moins un sous-ensemble soit reliée en série avec une de ces résistances (36; 64).

2. Procédé selon la revendication 1, **caractérisé en ce que** lesdites secondes électrodes (10) des pixels (4; 54) sont formées également par des électrodes propres (10) qui sont situées respectivement en regard desdites premières électrodes (6) et reliées au moins partiellement entre elles par des deuxièmes liaisons électriques (24; 58, 70, 72).

3. Procédé selon la revendication 2, **caractérisé en ce que** lesdites premières (28, 30) et deuxièmes (24) liaisons électriques présentent des croisements (40) en projection dans le plan général (42) de ladite plaquette (18), lesdites deuxièmes liaisons (24) étant agencées de manière à ce que ces croisements (40) interviennent entre lesdites premières électrodes (6) et lesdites résistances (36) respectives.

4. Procédé selon l'une des revendications 1 à 3, **caractérisé en ce que** lesdites premières liaisons (28) d'un même capteur sont agencées de manière à ce qu'elles soient coupées (44) lors du sciage de ce capteur (2) et que ses premières électrodes (6) soient alors isolées électriquement les unes des autres.

5. Procédé selon l'une des revendications précédentes, **caractérisé en ce que** lesdites résistances (36) et lesdites premières liaisons électriques (28, 30) sont agencées en couche(s) mince(s) essentiellement horizontalement du côté de la face supérieure (16) de ladite plaquette (18).

6. Procédé selon l'une des revendications 1 à 4, **caractérisé en ce que** lesdites premières liaisons électriques (56, 64, 68) sont formées au moins partiellement de pistes (68) situées à la face inférieure (66) de ladite plaquette (18) et de vias (64) traversant la plaquette (18).

7. Procédé selon la revendication 6, **caractérisé en ce que** lesdites résistances (64, 70) sont toutes agencées au moins partiellement au niveau des dits vias (64, 70).

8. Procédé selon la revendication 6 ou 7, **caractérisé en ce que** lesdits capteurs (2) sont formés chacun d'une matrice bidimensionnelle de pixels (4; 54).

9. Procédé selon l'une des revendications précédentes, **caractérisé en ce que** des plages de contacts électriques (38) pour connecter lesdites premières électrodes (6) sont formées entre celles-ci et les résistances respectives (36) et **en ce que**, lors de ladite étape C, lesdites premières électrodes (6) sont isolées entre elles.

10. Procédé selon l'une des revendications précédentes, **caractérisé en ce que** les valeurs desdites résistances (36; 64, 70) sont prévues sensiblement égales, pour définir une impédance sensiblement égale des pixels (4; 54), permettant de déposer uniformément une couche d'absorption (20) sur ces pixels (4; 54) par un procédé électrochimique.

## Claims

1. Method for manufacturing a plurality of pyroelectric sensors (2) by forming a thin pyroelectric film (8) on one face of the same wafer (18), particularly made of silicon, defining a general plane (42), each sensor (2) being formed of several pixels (4; 54) each defined by a first electrode (6) of its own located on one face of said pyroelectric film (8) and a second electrode (10) located on the other face of said film (8), this method comprising at least the following successive steps:
A) Forming first electric connections (28, 30; 56, 64, 68) between at least a subset of first electrodes (6) of said plurality of sensors (2) connecting these first electrodes (6) to at least one electric contact pad (32);
B) Electrically polarising said pyroelectric film (8) between the first (6) and second (10) electrodes by applying an electric voltage across said at least one electric contact pad (32) and said second electrodes (10) of the pixels (4; 54) corresponding to said at least one subset of first electrodes (6);
C) Electrically insulating said first (6) and/or second (10) electrodes of at least one sensor (2) from each other,
this method being **characterised in that**, during step A, electric resistors (36; 64) are formed and arranged such that each first electrode (6) of said at least one subset is series connected with one of these resistors (36; 64).

2. Method according to claim 1, **characterised in that** said second electrodes (10) of the pixels (4; 54) are also formed by electrodes (10) of their own that are located respectively facing said first electrodes (6) and connected at least partially to each other by second electric connections (24; 58, 70, 72).

3. Method according to claim 2, **characterised in that** said first (28, 30) and second (24) electric connections intersect (40) in projection onto the general plane (42) of said wafer (18), said second electric connections (24) being arranged such that these intersections (40) occur between said first electrodes (6) and said respective resistors (36).

4. Method according to any of claims 1 to 3, **characterised in that** said first connections (28) of a same sensor are arranged such that they are cut (44) when the sensor (2) is diced and such that its first electrodes (6) are then electrically insulated from each other.

5. Method according to any of the preceding claims, **characterised in that** said resistors (36) and said first electric connections (28, 30) are arranged in thin essentially horizontal film(s) on the side of the upper face (16) of said wafer (18).

6. Method according to any of claims 1 to 4, **characterised in that** said first electric connections (56, 64, 68) are formed at least partially of paths (68) located on the lower face (66) of said wafer (18) and of vias (64) passing through the wafer (18).

7. Method according to claim 6, **characterised in that** said resistors (64, 70) are all arranged at least partially at said vias (64, 70).

8. Method according to claim 6 or 7, **characterised in that** said sensors (2) are each formed of a two-dimensional pixel (4; 54) matrix.

9. Method according to any of the preceding claims, **characterised in that** electric contact pads (38) for connecting said first electrodes (6) are formed between the latter and the respective resistors (36) and that; during said step C, said first electrodes (6) are insulated from each other.

10. Method according to any of the preceding claims, **characterised in that** the values of said resistors (36; 64, 70) are provided to be substantially equal, to define a substantially equal impedance of the pixels (4; 54), allowing an absorption layer (20) to be uniformly deposited on these pixels (4; 54) by an electrochemical method.

## Patentansprüche

1. Verfahren zum Herstellen mehrerer pyroelektrischer Sensoren (2) durch Bilden einer pyroelektrischen Dünnschicht (8) auf einer Seite eines gleichen Wafers (18), das insbesondere aus Silicium besteht und eine allgemeine Ebene (42) definiert, wobei jeder Sensor (2) aus mehreren Pixeln (4; 54) gebildet ist, die jeweils durch eine erste zugeordnete Elektrode (6), die sich auf einer Seite der pyroelektrischen Schicht (8) befindet, und durch eine zweite Elektrode (10), die sich auf der gegenüberliegenden Seite dieser Schicht (8) befindet, definiert sind, wobei dieses Verfahren wenigstens die folgenden aufeinander folgenden Schritte umfasst:
A) Bilden erster elektrischer Verbindungen (28, 30; 56, 64, 68) wenigstens zwischen einer Untergruppe erster Elektroden (6) der mehreren Sensoren (2), die diese ersten Elektroden (6) mit wenigstens einem elektrischen Kontaktbereich (32) verbinden;
B) Elektrisches Vorspannen der pyroelektrischen Schicht (8) zwischen den ersten Elektroden (8) und den zweiten Elektroden (10) durch Anlegen einer elektrischen Spannung zwischen dem wenigstens einen elektrischen Kontaktbereich (32) und den zweiten Elektroden (10) jener Pixel (4; 54), die der wenigstens einen Untergruppe erster Elektroden (6) entsprechen;
C) Elektrisches Isolieren der ersten Elektroden (6) und/oder der zweiten Elektroden (10) wenigstens eines Sensors (2) voneinander,
wobei dieses Verfahren **dadurch gekennzeichnet ist, dass** im Schritt A die elektrischen Widerstände (36; 64) in der Weise angeordnet sind, dass jede erste Elektrode (6) der wenigstens einen Untergruppe mit einem dieser Widerstände (36; 64) in Reihe geschaltet ist.

2. Verfahren nach Anspruch 1, **dadurch gekennzeichnet, dass** die zweiten (10) der Pixel (4; 54) ebenfalls durch zugeordnete Elektroden (10) gebildet sind, die sich jeweils gegenüber der ersten Elektroden (6) befinden und durch zweite elektrische Verbindungen (24; 58, 70, 72) wenigstens zum Teil miteinander verbunden sind.

3. Verfahren nach Anspruch 2, **dadurch gekennzeichnet, dass** die ersten elektrischen Verbindungen (28, 30) und die zweiten elektrischen Verbindungen (24) in der Projektion auf die allgemeine Ebene (42) des Plättchens (18) Kreuzungspunkte (40) aufweisen, wobei die zweiten elektrischen Verbindungen (24) in der Weise angeordnet sind, dass diese Kreuzungspunkte (40) zwischen den ersten Elektroden (6) und den entsprechenden Widerständen (36) liegen.

4. Verfahren nach einem der Ansprüche 1 bis 3, **dadurch gekennzeichnet, dass** die ersten Verbindungen (28) desselben Sensors in der Weise angeordnet sind, dass sie beim Aussagen dieses Sensors (2) durchgeschnitten werden und dessen erste Elektroden (6) dann voneinander elektrisch isoliert sind.

5. Verfahren nach einem der vorhergehenden Ansprüche, **dadurch gekennzeichnet, dass** die Widerstände (36) und die ersten elektrischen Verbindungen (28, 30) in einer oder in mehreren Dünnschichten im Wesentlichen horizontal auf der oberen Seite (16) des Plättchens (18) angeordnet sind.

6. Verfahren nach einem der Ansprüche 1 bis 4, **dadurch gekennzeichnet, dass** die ersten elektrischen Verbindungen (56, 64, 68) wenigstens teilweise aus Bahnen (68), die sich auf der Unterseite (66) des Plättchens (18) befinden, und aus Durchgangslöchern (64) durch das Plattchen (18) gebildet sind.

7. Verfahren nach Anspruch 6, **dadurch gekennzeichnet, dass** alle Widerstände (64, 70) wenigstens teilweise auf Höhe der Durchgangslöcher (64, 70) angeordnet sind.

8. Verfahren nach Anspruch 6 oder 7, **dadurch gekennzeichnet, dass** die Sensoren (2) jeweils aus einer zweidimensionalen Matrix aus Pixeln (4; 54) gebildet sind.

9. Verfahren nach einem der vorhergehenden Ansprüche, **dadurch gekennzeichnet, dass** die elektrischen Kontaktbereiche (38) für die Verbindung der ersten Elektroden zwischen diesen und den entsprechenden Widerständen (36) gebildet sind und dass im Schritt C die ersten Elektroden (6) voneinander isoliert sind.

10. Verfahren nach einem der vorhergehenden Ansprüche, **dadurch gekennzeichnet, dass** die Werte der Widerstande (36; 64, 70) im Wesentlichen gleich vorgesehen sind, um eine im Wesentlichen gleiche Impedanz der Pixel (4; 54) zu definieren, was die gleichmässige Ablagerung einer Absorptionsschicht (20) auf diesen Pixeln (4; 54) durch ein elektrochemisches Verfahren ermöglicht.
